# EUROPEAN PATENT APPLICATION

(11) **EP 4 550 395 A1**
(43) Date of publication of application: **07.05.2025**
(21) Application number: 24170682.9
(22) Date of filing: 17.04.2024
(51) Int. Cl.: H01L 21/76, H01L 21/762

(54) **DEVICE WITH ISOLATION STRUCTURES**

(30) Priority: 30.10.2023 US 202318385268
(71) Applicant: GlobalFoundries U.S. Inc., Malta, NY 12020 (US)
(72) Inventor: DEANGELIS, Jacob M., Essex Junction, VT, 05452 (US); WILLS, Trevor S., Essex Junction, VT, 05452 (US); LEVY, Mark D., Essex Junction, VT, 05452 (US); PORTER, Spencer H., Essex Junction, VT, 05452 (US); CUCCI, Brett T., Essex Junction, VT, 05452 (US); KRISHNASAMY, Rajendran, Essex Junction, VT, 05452 (US)
(74) Representative: Lambacher, Michael

(57) **Abstract**

The present disclosure relates to semiconductor structures and, more particularly, to devices with isolation structures and methods of manufacture. The structure includes: a stack of semiconductor materials; a semiconductor substrate under the stack of semiconductor materials; a trench filled with in insulator material; and a damaged region of the stack of semiconductor materials extending from at least a bottom of the insulator material to the semiconductor substrate.

## Description

### BACKGROUND

This invention was made with government support under Contract # HQ0727790700 awarded by the Defense Microelectronics Activity (DMEA). The government has certain rights in the invention.

The present disclosure relates to semiconductor structures and, more particularly, to devices with isolation structures and methods of manufacture.

A high-electron-mobility transistor (HEMT) is a field-effect transistor incorporating a junction between two materials with different band gaps as the channel instead of a doped region (as is generally the case for a MOSFET). A commonly used material combination is GaAs with AlGaAs, although there are other material variations dependent on the application of the device. HEMTs incorporating gallium nitride, for example, provide high-power performance.

HEMTs are able to operate at higher frequencies than ordinary transistors, up to millimeter wave frequencies. Accordingly, HEMTs are used in high-frequency products such as cell phones, satellite receivers, voltage converters, and radar equipment. The HEMT can also be used in low power applications such as low power amplifiers. HEMTs, though, can exhibit high gate to drain capacitance (Cgd), which can change with application of different voltages.

### SUMMARY

In an aspect of the disclosure, a structure comprises: a stack of semiconductor materials; a semiconductor substrate under the stack of semiconductor materials; a trench in the stack of semiconductor materials and filled with an insulator material; and a damaged region of the stack of semiconductor materials extending from at least a bottom of the insulator material to the semiconductor substrate.

Additional features of the structure are set forth in dependent claims 2 to 8.

In an aspect of the disclosure, a structure comprises: a wide-bandgap semiconductor layer of a semiconductor substrate; a device over the wide-bandgap semiconductor layer a trench in the wide-bandgap semiconductor layer which is filled with in insulator material surrounding the device; and a damaged region of the wide-bandgap semiconductor layer extending from at least a bottom of the trench to the semiconductor substrate and surrounding the device.

Additional features of the structure are set forth in dependent claims 10 to 14.

In an aspect of the disclosure, a method comprises: forming a stack of semiconductor materials on a semiconductor substrate; forming a trench partially in the stack of semiconductor materials; damaging a region of the stack of semiconductor materials extending from at least a bottom of the trench to the semiconductor substrate; and filling the trench with insulator material.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure in accordance with additional aspects of the present disclosure.
FIG. 3 shows a structure in accordance with additional aspects of the present disclosure.
FIG. 4 shows a structure in accordance with additional aspects of the present disclosure.
FIGS. 5A and 5B show a top view of different structures in accordance with aspects of the present disclosure.
FIGS. 6A-6C show respective fabrication processes for manufacturing the structure of FIG. 1 in accordance with aspects of the present disclosure.

### DETAILED DESCRIPTION

The present disclosure relates to semiconductor structures and, more particularly, to devices with isolation structures and methods of manufacture. More specifically, the devices may be high-electron-mobility transistors and the isolation structures may be damaged substrate regions surrounding the devices to form a seal structure. Advantageously, the structures achieve improved electrical and physical isolation by preventing leakage current and moisture ingress.

In more specific embodiments, the present disclosure is directed to a High Electron Mobility Transistor (HEMT) comprising a wide-bandgap semiconductor layer (e.g., AlGaN) over a substrate (e.g., Si substrate) and an isolation region in the wide-bandgap semiconductor layer surrounding a portion of the wide-bandgap semiconductor layer. In more specific embodiments, the isolation region surrounds the HEMT. The isolation region may comprise a trench filled with an insulator material and high-density crystalline dislocation region surrounding the insulator material and extending to the underlying substrate. For example, the high-density crystalline dislocation region may be arranged along a bottom surface and, in embodiments, sidewalls of a trench. The high-density crystalline dislocation region may include a damaged portion of the wide-bandgap semiconductor layer, which has a higher resistivity than the wide-bandgap semiconductor layer and an underlying substrate.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

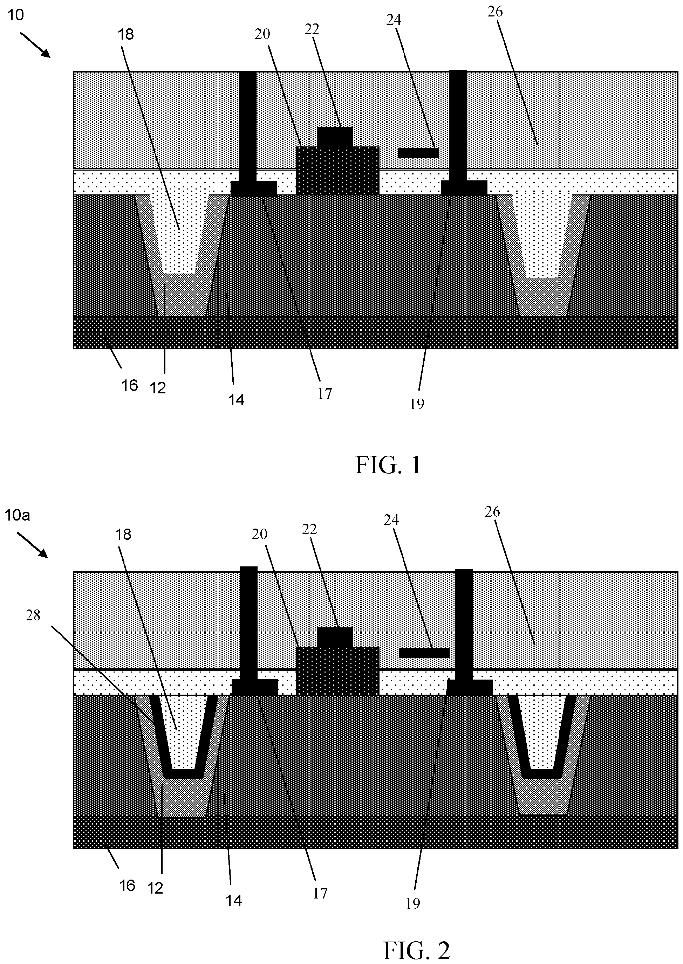

FIG. 1 shows a structure and respective fabrication processes in accordance with aspects of the present disclosure. More specifically, the structure 10 of FIG. 1 includes a high-density crystalline dislocation region (e.g., damaged region) 12 extending through a wide-bandgap semiconductor layer 14 and, in embodiments, extending onto a surface of or extending within an underlying semiconductor substrate 16. The high-density crystalline dislocation region 12 may be formed through a trench, prior to being filled with a dielectric material 18. In this way, the high-density crystalline dislocation region 12 may surround the dielectric material 18 and, more specifically, may surround the trench which is filled with the dielectric material 18. The high-density crystalline dislocation region 12 will also physically and electrically isolate a device 20. Accordingly, high-density crystalline dislocation region 12 will improve electrical and physical isolation by preventing leakage current and moisture ingress from reaching the device 20, thus improving electrical and reliability performance.

In more specific embodiments, the structure 10 of FIG. 1 comprises a wide-bandgap semiconductor layer 14 over the underlying semiconductor substrate 16. The wide-bandgap semiconductor layer 14 may be, for example, an AlGaN stack of materials as is known in the art. For example, and as a non-limiting illustrative example, the wide-bandgap semiconductor layer 14 may comprise, in a layered stack of semiconductor materials, a seed layer, e.g., AlN, on the underlying semiconductor substrate 16, a buffer layer (e.g., AlGaN) and a channel layer, e.g., GaN. In embodiments, the device 20 (e.g., p-doped GaN gate structure) may be provided over the channel layer. The stack of semiconductor materials may be formed by conventional epitaxial growth processes or other known deposition methods, e.g., chemical vapor deposition (CVD).

The semiconductor substrate 16 may comprise a semiconductor handle substrate material comprising Si; although other suitable materials are contemplated herein including, but not limited to, SiGe, SiGeC, SiC, GaAs, InAs, InP, and other III/V or II/VI compound semiconductors. In preferred embodiments, the semiconductor material substrate may comprise a suitable crystal orientation, e.g., (111).

The semiconductor substrate 16 may also comprise a semiconductor-on-insulator substrate utilized in semiconductor-on-insulator technologies. The semiconductor-on-insulator technologies comprise, from bottom to top, a handle substrate, a buried insulator layer (i.e., substrate) and a top semiconductor layer (semiconductor-on-insulator substrate). The handle substrate and top semiconductor layer may include a semiconductor material such as, for example, Si, Ge, SiGe, SiC, SiGeC, a III-V compound semiconductor, a II-VI compound semiconductor or any combinations thereof. The buried insulator layer may include, e.g., oxide, silicon dioxide, silicon nitride, silicon oxynitride, boron nitride or a combination thereof. In embodiments, the buried insulator layer may be formed by a deposition process, e.g., CVD, plasma enhanced chemical vapor deposition (PECVD), physical vapor deposition (PVD), or may be formed by an oxygen implant process or a thermal growth process as is known in the art such that no further explanation is required for a complete understanding of the present disclosure. The top semiconductor layer can be formed by a deposition process, such as CVD or PECVD, or using a smart cut process as is known in the art.

Still referring to FIG. 1, the device (e.g., gate structure) 20 may be provided between a source region 17 and a drain region 19 (e.g., active regions) of the channel layer. The device 20 may be a HEMT comprising semiconductor material formed, e.g., deposited and patterned, on the stack of semiconductor materials, e.g., the wide-bandgap semiconductor layer 14. In embodiments, the semiconductor material of the device 20 comprises, e.g., p-doped GaN (an e-mode device) or a metal (a d-mode device). The semiconductor material may be epitaxially grown with an in-situ doping, e.g., p-type doping, as is known in the art. A metal stack 22, e.g., TiN, TiAl and/or TaN, may be provided on top of and contacting the semiconductor material of the device 20. A metal field plate 24, e.g., TiN, TiAl and/or TaN, connects to a source region 17. The metal stack 20 and the metal field plate 24 may be deposited by a conventional deposition method (e.g., CVD), followed by conventional lithography and etching (e.g., patterning) processes.

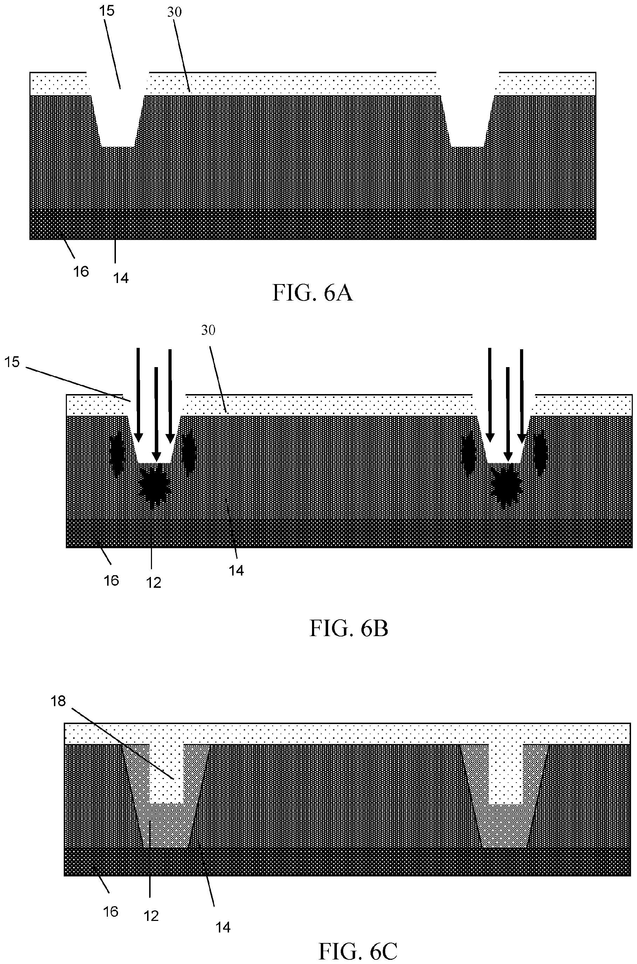

The structure further comprises an isolation structure. The isolation structure comprises a high-density crystalline dislocation region 12 provided at the outer edges of the drain region and source region 17, and more specifically, surrounding the device 20, whether it be an active device or a passive device. The high-density crystalline dislocation region 12 may be formed by an ion implant process as described with respect to FIG. 6B. In embodiments, the high-density crystalline dislocation region 12 may have a tapered sidewall profile (or a straight sidewall profile as further described herein), extending from a top surface to a bottom surface of the wide-bandgap semiconductor layer 14.

In preferred embodiments, the high-density crystalline dislocation region 12 may extend completely or partially through the wide-bandgap semiconductor layer 14 over the underlying semiconductor substrate 16. Moreover, the high-density crystalline dislocation region 12 may extend onto the surface or extend into the underlying semiconductor substrate 16. In this way, the high-density crystalline dislocation region 12 will completely isolate the device 20, both electrically and from moisture ingress. The isolation region further comprises dielectric material 18 deposited within a trench. The high-density crystalline dislocation region 12 may surround the dielectric material 18. The dielectric material 18 may be an oxide material or other low-k dielectric material as is known in the art. The dielectric material 18 may also extend over a top surface of the wide-bandgap semiconductor layer 14. In embodiments, the high-density crystalline dislocation region 12 and the dielectric material 18 may have tapered sidewalls.

An interlevel dielectric material 26 may be provided over the entire structure, including surrounding the metal field plate 24, metal stack 22 and device 20. The interlevel dielectric material 26 may be a SiO₂ or nitride or combinations thereof in a stacked configuration.

FIG. 2 shows a structure 10a in accordance with additional aspects of the present disclosure. In FIG. 2, the structure 10a includes a liner 28 on surfaces of a trench filled with the dielectric material 18. In this way, the liner 28 is provided on sidewalls and a bottom surface of the dielectric material 18. The liner 28 may also be between and in direct contact with both the dielectric material 18 and the high-density crystalline dislocation region 12. The liner 28 may be nitride or other insulator material 28, different than the dielectric material 18. The remaining features of the structure 10a of FIG. 2 are similar to structure 10 of FIG. 1.

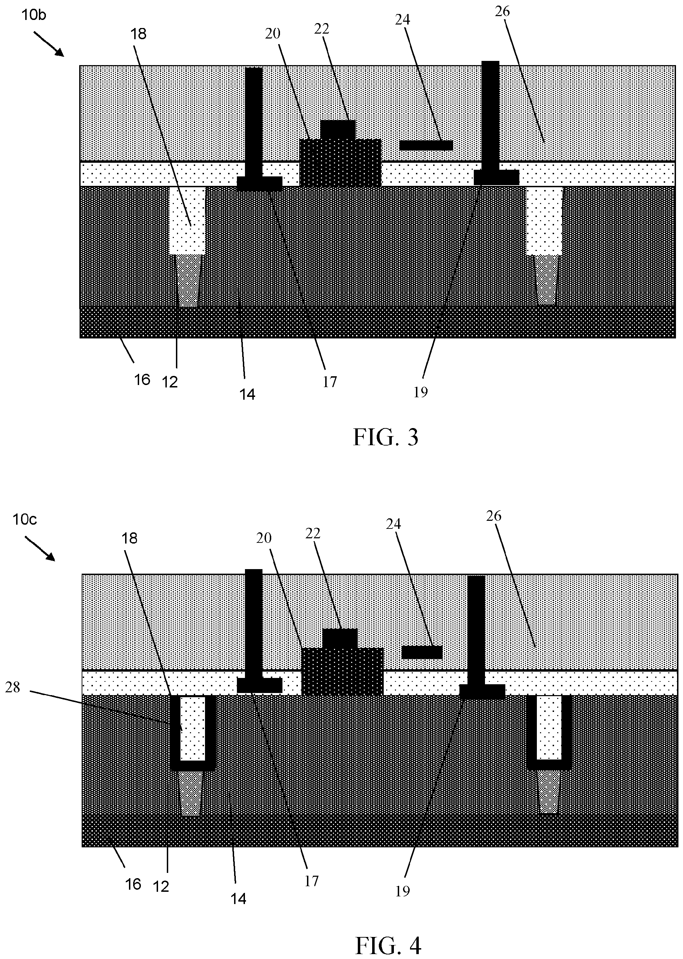

FIG. 3 shows a further structure 10b in accordance with aspect of the present disclosure. In FIG. 3, for example, the dielectric material 18 includes straight vertical sidewalls. This is due to the trench, which is filled with the dielectric material 18, also having straight vertical sidewalls. Moreover, the high-density crystalline dislocation region 12 is provided below the dielectric material 18, extending from a bottom surface of the dielectric material 18 to a top of or extending into the underlying semiconductor substrate 16. In this embodiment, the high-density crystalline dislocation region 12 may also have straight vertical sidewalls directly below the dielectric material 18. The remaining features of the structure 10b of FIG. 3 are similar to the structure 10 of FIG. 1.

FIG. 4 shows another structure 10c in accordance with aspects of the present disclosure. In this structure, the liner 28 is provided on surfaces of the trench filled with the dielectric material 18. As in the structure 10b of FIG. 3, the dielectric material 18 includes straight vertical sidewalls due to the trench being formed with such straight vertical sidewalls. Moreover, as in the structure 10b of FIG. 3, the high-density crystalline dislocation region 12 is provided below the dielectric material 18, extending from a bottom surface of the dielectric material 18 to a top of or extending into the underlying semiconductor substrate 16. In this embodiment, the high-density crystalline dislocation region 12 may also have straight vertical sidewalls directly below the dielectric material 18. The remaining features of the structure 10c of FIG. 4 are similar to the structure 10 of FIG. 1.

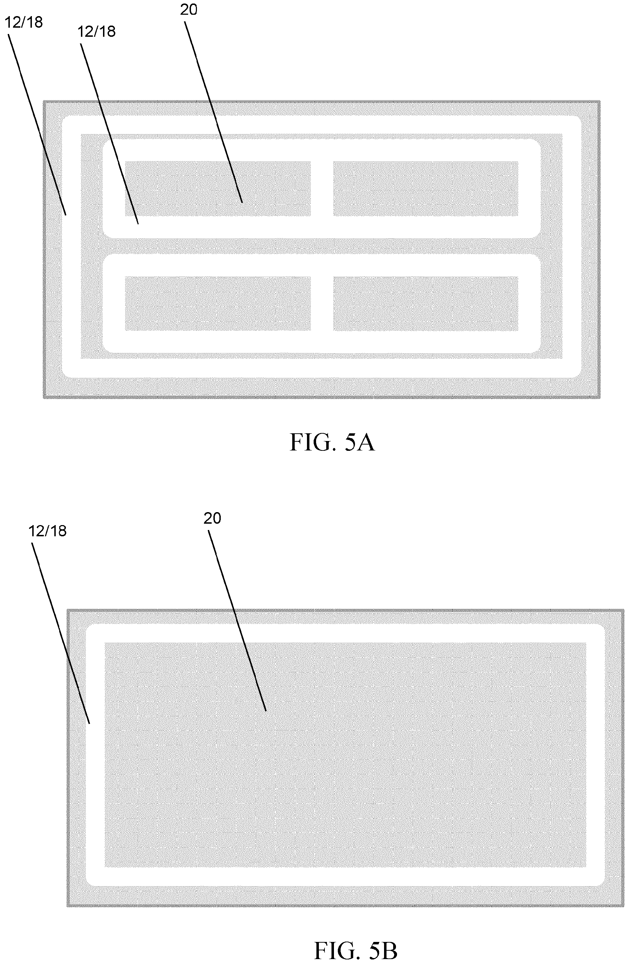

FIG. 5A shows a top view of the structure in accordance with aspects of the present disclosure. In this view it is shown that the high-density crystalline dislocation region 12 and the dielectric material 18 (e.g., isolation structure) surround individual devices 20. In addition, the high-density crystalline dislocation region 12 and the dielectric material 18 (e.g., isolation structure) surround several devices 20. It should be understood that although four devices are shown in FIG. 5A, any number of devices are contemplated herein. In FIG. 5B, a single high-density crystalline dislocation region 12 and the dielectric material 18 (e.g., isolation structure) surround several devices 20.

FIGS. 6A-6C show respective fabrication processes for manufacturing the structure of FIG. 1 in accordance with aspects of the present disclosure. As shown in FIG. 6A, for example, a trench 15 is formed in an optional insulator material (e.g., oxide material) 30 and partly through the wide-bandgap semiconductor layer 14. In embodiments, the trench 15 may have angled sidewalls and will not extend entirely through the wide-bandgap semiconductor layer 14.

The trench 15 can be formed by conventional lithography, etching and deposition methods known to those of skill in the art. For example, a resist formed over the insulator material 30 is exposed to energy (light) and developing the exposed resist layer utilizing a conventional resist developer to form a pattern (opening). An etching process with a selective chemistry, e.g., reactive ion etching (RIE), will be used to transfer the pattern into the insulator material 30 and wide-bandgap semiconductor layer 14, through the openings of the resist. The resist may be removed by a conventional oxygen ashing process or other known stripants.

In FIG. 6B, a dopant is implanted through the trench 15 and into the wide-bandgap semiconductor layer 14. The dopant may be, for example, B, C, N, P, Ar, Ge, As, or Xe. In embodiments, the insulator material 30 may act as an implantation mask which has a thickness and stopping power sufficient to block masked areas against receiving a dose of the implanted ions.

The implant process will damage the wide-bandgap semiconductor layer 14 resulting in the high-density crystalline dislocation region 12. In embodiments, the high-density crystalline dislocation region 12 will extend into the wide-bandgap semiconductor layer 14 at the sidewalls of the trench 15 due to the tapered sidewalls of the trench 15. The high-density crystalline dislocation region 12 may also have tapered sidewalls and extend from a top surface of the wide-bandgap semiconductor layer 14 to a surface of or extend within the underlying semiconductor substrate 16. The depth of the high-density crystalline dislocation region 12 can be tuned based on the concentration and energy of the ion implantation process, as well as the depth of the trench 15. For example, nitrogen can be implanted at 3000 KeV.

In alternative embodiments, when the sidewalls of the trench 15 are straight and the ion implantation process is straight down, the high-density crystalline dislocation region 12 will extend from a bottom of the trench 15 (not through the sidewalls) of the underlying semiconductor substrate 16. In further alternative embodiments, using an angled ion implantation process, the high-density crystalline dislocation region 12 can extend through the sidewalls of the trench 15 into the wide-bandgap semiconductor layer 14, regardless of whether the sidewalls are tapered or straight.

In FIG. 6C, insulator material 18 can be deposited within the trench 15 by a conventional deposition process, e.g., CVD. The insulator material 18 on top of the structure can also be planarized by a conventional chemical mechanical planarization (CMP) process. In embodiments, the trench 15 can be lined with a liner material prior to the deposition of the insulator material as shown in FIGS. 2 and 4. In this embodiment, the liner material may be N. Thereafter the device 20 can be fabricated as shown, for example, in FIG. 1.

The structures can be utilized in system on chip (SoC) technology. The SoC is
an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a stack of semiconductor materials;
a semiconductor substrate under the stack of semiconductor materials;
a trench in the stack of semiconductor materials and filled with an insulator material; and
a damaged region of the stack of semiconductor materials extending from at least a bottom of the insulator material to the semiconductor substrate.

2. The structure of claim 1, wherein the stack of semiconductor materials comprises wide-bandgap semiconductor material.

3. The structure of claim 1 or claim 2, wherein the damaged region comprises a high-density crystalline dislocation region of the stack of semiconductor materials.

4. The structure of one of claims 1 to 3, wherein the damaged region and the insulator material comprise tapered sidewalls, and, optionally, wherein the tapered sidewalls and a bottom surface of the insulator material comprise a liner material.

5. The structure of one of claims 1 to 3, wherein the insulator material and the damaged region comprise straight vertical sidewalls, and, optionally, wherein the straight vertical sidewalls and a bottom surface of the insulator material are lined with a liner material.

6. The structure of one of claims 1 to 5, wherein the damaged region extends entirely through the semiconductor stack of material and into the semiconductor substrate, or wherein the damaged region extends partially through the semiconductor stack of material and into the semiconductor substrate.

7. The structure of one of claims 1 to 6, wherein the damaged region surrounds an active device.

8. The structure of one of claims 1 to 7, wherein the damaged region comprises several damaged regions at least one of which surrounds multiple active devices.

9. A structure, comprising:
a wide-bandgap semiconductor layer of a semiconductor substrate;
a device over the wide-bandgap semiconductor layer;
a trench in the wide-bandgap semiconductor layer which is filled with in insulator material surrounding the device; and
a damaged region of the wide-bandgap semiconductor layer extending from at least a bottom of the trench to the semiconductor substrate and surrounding the device.

10. The structure of claim 9, wherein the trench comprises tapered sidewalls, and/or wherein the trench is lined with an insulator liner, and/or wherein the trench partially extends within the wide-bandgap semiconductor layer.

11. The structure of claim 9 or claim 10, wherein the damaged region extends into the semiconductor substrate.

12. The structure of one of claims 9 to 11, wherein the damaged region comprises a high-density crystalline dislocation region.

13. The structure of one of claims 9 to 12, wherein the damaged region extends from a top surface of the wide-bandgap semiconductor to a bottom surface of the wide-bandgap semiconductor.

14. The structure of one of claims 9 to 13, wherein the damaged region comprises several damaged regions each of which surround a single device and one of which surrounds multiple devices.

15. A method comprising:
forming a stack of semiconductor materials on a semiconductor substrate;
forming a trench partially in the stack of semiconductor materials;
damaging a region of the stack of semiconductor materials extending from at least a bottom of the trench to the semiconductor substrate; and
filling the trench with insulator material.
